# EUROPEAN PATENT APPLICATION

(11) **EP 4 529 374 A1**
(43) Date of publication of application: **26.03.2025**
(21) Application number: 22944264.5
(22) Date of filing: 31.05.2022
(51) Int. Cl.: H05K 7/20

(54) **CONTROL MODULE, HEAT DISSIPATION SYSTEM AND ELECTRONIC APPARATUS**

(71) Applicant: Shenzhen Yinwang Intelligent Technologies Co., Ltd., Shenzhen, Guangdong 518129 (CN)
(72) Inventor: PENG, Yaofeng, Shenzhen, Guangdong 518129 (CN)
(74) Representative: Gill Jennings & Every LLP
(86) International application number: PCT/CN2022/096485
(87) International publication number: WO 2023/230928

(57) **Abstract**

This application provides a control module (10), a heat dissipation system, and an electronic device. The control module (10) includes a cooling plate (300), a first housing (110), a first circuit board (120), a second housing (210), and a second circuit board (220). The cooling plate (300) includes a first surface (301) and a second surface (302). The first housing (110) encloses a first accommodation space (101) with the first surface (301). The second housing (210) encloses a second accommodation space (102) with the second surface (302). Both the first housing (110) and the second housing (210) are detachably connected to the cooling plate (300) in a sealed manner. The first circuit board (120) and the second circuit board (220) are respectively located in the first accommodation space (101) and the second accommodation space (102). A first chip (121) and a first heat conduction structure (122) are disposed on the first circuit board (120). The first heat conduction structure (122) is disposed between the first chip (121) and the first surface (301). The cooling plate (300) dissipates heat for the first chip (121) by using the first heat conduction structure (122). A second chip (221) and a second heat conduction structure (222) are disposed on the second circuit board (220). The cooling plate (300) dissipates heat for the second chip (221) by using the second heat conduction structure (222). The control module (10) in this application has good heat dissipation effect, and a volume is reduced, thereby further ensuring sealing performance and maintenance convenience of the circuit board.

## Description

### TECHNICAL FIELD

This application relates to the field of heat dissipation technologies, and in particular, to a control module, a heat dissipation system, and an electronic device.

### BACKGROUND

With the development of intelligent technologies, information interconnection inside an electronic device and between the electronic device and the outside can be implemented by using a controller, and a working load of the controller greatly increases, resulting in a significant increase in heat generation. For example, there is a growing number of in-vehicle electronic devices in intelligent vehicles, such as a radar, a camera, a motor, an anti-lock braking system, a four-wheel drive system, an electronically controlled automatic transmission, an active suspension system, a supplementary restraint system, and a multi-directional adjustable electronically controlled seat. These electronic devices are usually connected to an electronic control unit (also referred to as a driving computer). The electronic control unit needs to process an increasingly large amount of data, and a requirement for computing power of the electronic control unit also constantly increases. A working load of the electronic control unit increases greatly, resulting in a significant increase in heat generation. In addition, the electronic control units are gradually centralized, leading to a more prominent problem of difficulty in heat dissipation. To enable the electronic control unit to work efficiently and stably in a case of a significant increase in heat generation, it is necessary to improve a heat dissipation capability of the electronic control unit and enhance protection for the electronic control unit. However, in a heat dissipation solution in a conventional technology, heat dissipation effect is poor, a circuit board in an electronic control unit is likely to be damaged during maintenance of the electronic control unit, and a volume is large.

### SUMMARY

This application provides a control module with good heat dissipation effect and a small volume.

According to a first aspect, this application provides a control module. The control module includes a cooling plate, a first housing, a first circuit board, a second housing, and a second circuit board. The cooling plate includes a first surface and a second surface that are arranged along a thickness direction. The first housing is located on a side same as the first surface and encloses a first accommodation space with the first surface. The first housing is detachably connected to the cooling plate in a sealed manner. The first circuit board is located in the first accommodation space and is detachably connected to the first housing. A first chip is disposed on a side that is of the first circuit board and that faces the first surface. A first heat conduction structure is disposed between the first chip and the first surface. The cooling plate dissipates heat for the first chip by using the first heat conduction structure. The second housing is located on a same side as the second surface and encloses a second accommodation space with the second surface. The second housing is detachably connected to the cooling plate in a sealed manner. The second circuit board is located in the second accommodation space and is detachably connected to the second housing. A second chip is disposed on a side that is of the second circuit board and that faces the second surface. A second heat conduction structure is disposed between the second chip and the second surface. The cooling plate dissipates heat for the second chip by using the second heat conduction structure.

The cooling plate can maintain a low temperature, and is configured to cool the first chip and the second chip, or may be configured to cool the first circuit board and the second circuit board. In an implementation, a temperature of the cooling plate may be adjusted based on a heat generation status of the first chip and the second chip, to achieve good cooling effect. The first surface and the second surface of the cooling plate are disposed opposite each other along a first direction. In an implementation, the cooling plate is a cuboid, the first direction is a thickness direction of the cooling plate, and the first surface and the second surface are two surfaces with largest areas of the cooling plate, so that high cooling efficiency is ensured and a volume of the cooling plate is reduced.

In an implementation, the cooling plate is of a hollow structure, and there is coolant inside the cooling plate. The cooling plate is further provided with a liquid inlet and a liquid outlet. Heat exchange is implemented for the first chip and the second chip by using the coolant, to cool the first chip and the second chip. In another implementation, the cooling plate may also be in another shape. Specifically, a shape of the cooling plate may be adjusted based on the first housing, the second housing, and a surrounding environment.

In some implementations, the cooling plate is an air-cooled cooling plate. A fan is disposed in the cooling plate, and the fan drives air circulation inside and outside the cooling plate, to implement heat exchange and cool the first chip and the second chip.

In an implementation, an entirety of the circuit board and the housing is referred to as an electronic control unit. To be specific, the first circuit board and the first housing are referred to as a first electronic control unit, the second circuit board and the second housing are referred to as a second electronic control unit, and the first electronic control unit and the second electronic control unit each may be configured to control an autonomous driving system, an in-vehicle entertainment system, a communication system, and the like. In an implementation, the first circuit board may also be separately referred to as the first electronic control unit, and the second circuit board may be referred to as the second electronic control unit.

In an implementation, the first electronic control unit and the second electronic control unit may be configured to control other functional systems or control a plurality of functional systems according to requirements, and the first electronic control unit and the second electronic control unit may also coordinately control a same functional system.

The first circuit board, the second circuit board, and the cooling plate are disposed in parallel or approximately in parallel. The first chip is fastened to the first circuit board and is electrically connected to the first circuit board. One or more first chips may be disposed on the first circuit board. Functions of the plurality of first chips may be the same or may be different. The second chip is fastened to the second circuit board and is electrically connected to the second circuit board. One or more second chips may be disposed on the second circuit board. Functions of the plurality of first chips may be the same or may be different. In addition, quantities and functions of the second chips and the first chips may be the same or different. This is not limited in this application.

A heat source in the control module is mainly heat generated by the first chip and the second chip. Therefore, heat dissipation is directly performed on the first chip and the second chip, to cool the first electronic control unit and the second electronic control unit. When the first chip and the second chip are directly in contact with the cooling plate, heat dissipation effect is not good. If different first chips or different second chips have different thicknesses in the first direction, it is difficult for a chip with a small thickness to be attached to the cooling plate, and some chips cannot achieve good heat dissipation effect. In this application, the first heat conduction structure is added on a side that is of the first chip and that is away from the first circuit board along the first direction, and the second heat conduction structure is added on a side that is of the second chip and that is away from the second circuit board along the first direction. The first heat conduction structure and the second heat conduction structure are disposed to fill an air gap between the chip and the cooling plate, and the heat conduction structures can cover an uneven surface of the chip, thereby increasing a heat dissipation area of the chip. In this way, heat of the chip can be better conducted to the cooling plate for heat dissipation. This can improve efficiency and a service life of the electronic control unit. In addition, the heat conduction structures are disposed, so that each chip of a different thickness can be indirectly in contact with the cooling plate, and heat dissipation is implemented. Still further, the first heat conduction structure may be configured to support the first chip, and the second heat conduction structure may be configured to support the second chip, thereby improving structural strength of the first circuit board and the second circuit board.

In an implementation, the first heat conduction structure and the second heat conduction structure have features such as flexibility and elasticity. In this way, the first heat conduction structure can cover all of a surface that is of the first chip and that is away from the first circuit board along the first direction, and the second heat conduction structure can cover all of a surface that is of the second chip and that is away from the second circuit board along the first direction, so that heat dissipation can be better implemented on the first chip and the second chip. In an implementation, when there is a problem of high temperature in a part that is of the first circuit board or the second circuit board and on which no chip is disposed, a heat conduction structure may also be added at a corresponding position, to transfer heat at the position to the cooling plate for heat dissipation by using the heat conduction structure.

In this application, the first surface and the second surface of the cooling plate are fully used to cool the first chip and the second chip respectively, so that energy consumption can be reduced. In addition, in comparison with an implementation in which only one cooling plate is used to cool one electronic control unit, in this application, one cooling plate can be used to cool two electronic control units, so that a volume of the control module is smaller, to adapt to a requirement of a small size scenario and facilitate installation.

The first housing is configured to protect the first circuit board, and prevent the first circuit board from being damaged due to collision with an external component. The first housing and the first surface jointly enclose the first accommodation space. The first accommodation space is a sealed space. The first circuit board may be sealed and isolated from an external environment, so that the first circuit board is dustproof and waterproof. In this application, a sealing level of the first circuit board may further reach IP67 or higher. The first accommodation space can also prevent external water vapor from entering the first accommodation space and condensing into condensate water due to an excessively low temperature, and the condensate water falls on the first circuit board, resulting in damage to the first circuit board. In addition, the cooling plate implements a cooling function, and serves as a part to enclose the first accommodation space, implementing full utilization of the cooling plate. Additionally, the first heat conduction structure is directly attached to the cooling plate, thereby achieving better heat dissipation effect. The cooling plate may also cool air in the first accommodation space to reduce a temperature of the first circuit board. In an implementation, desiccant is further placed in the first accommodation space, and is used to remove moisture in the first accommodation space. This ensures that the first accommodation space is in a dry state, and prevents the moisture in the first accommodation space from condensing onto the first circuit board due to an excessively low temperature, resulting in damage to the first circuit board. If the first accommodation space is not a sealed space, external water vapor is likely to penetrate into the first accommodation space, the desiccant is likely to be inactive. Consequently, frequent replacement of the desiccant also leads to high costs, which is time-consuming and labor-consuming. In this application, the first circuit board can be better protected from water vapor by disposing the first accommodation space as a sealed space and using the desiccant.

A detachable connection means that two interconnected components can be separated without being damaged. For example, the first housing is detachably connected to the cooling plate, which means that the first housing is fastened relative to the cooling plate during normal use, and when maintenance is required, the first housing and the cooling plate can be separated, but the first housing or the cooling plate is not damaged. Because the first housing is detachably connected to the cooling plate and the first circuit board is detachably connected to the first housing, when the first circuit board is faulty, the first circuit board can be completely detached from the first housing for maintenance without damaging the first housing and the first circuit board, thereby improving maintenance convenience of the first circuit board. Alternatively, when the first circuit board needs to be replaced, the old first housing may be reused to reduce costs. Besides, when the first housing is damaged, only the first housing may be replaced, and the first circuit board may be detached and assembled to a new first housing.

The second housing is configured to protect the second circuit board and prevent the second circuit board from being damaged due to collision with an external component. The second housing and the second surface jointly enclose the second accommodation space. The second accommodation space is a sealed space. The second circuit board may be sealed and isolated from an external environment, so that the second circuit board is dustproof and waterproof. In this application, a sealing level of the first circuit board may further reach IP67 or higher. The second accommodation space can also prevent external water vapor from entering the second accommodation space and condensing onto the second circuit board due to an excessively low temperature, resulting in damage to the second circuit board. In addition, the cooling plate implements a cooling function, and serves as a part to enclose the second accommodation space, implementing full utilization of the cooling plate. Additionally, the second heat conduction structure is directly attached to the cooling plate, thereby achieving better heat dissipation effect. The cooling plate may also cool air in the second accommodation space to reduce a temperature of the second circuit board. Desiccant may also be placed in the second accommodation space, and is used to remove moisture in the second accommodation space. Because the second housing is detachably connected to the cooling plate and the second circuit board is detachably connected to the second housing, when the second circuit board is faulty, the second circuit board can be completely detached from the second housing for maintenance without damaging the second housing and the second circuit board, thereby improving maintenance convenience of the second circuit board. Alternatively, when the second circuit board needs to be replaced, the old second housing may be reused to reduce costs. Besides, when the second housing is damaged, only the second housing may be replaced, and the second circuit board may be detached and assembled to a new second housing.

In an implementation, the second housing and the first housing are equal in size and shape, and orthographic projections of the second housing and the first housing on the cooling plate cover surfaces of the cooling plate, so that utilization of the cooling plate can be maximized. In another implementation, there is also a case in which the second housing and the first housing have different sizes. This is not limited in this application. For example, an orthographic projection of the first housing on the cooling plate is located in the first surface, or an orthographic projection area of the first housing on the cooling plate is less than an area of the first surface. An orthographic projection of the second housing on the cooling plate is located in the second surface, or an orthographic projection area of the second housing on the cooling plate is less than an area of the second surface. For example, the orthographic projection area of the first housing on the cooling plate is greater than the area of the first surface, and the orthographic projection area of the second housing on the cooling plate is greater than the area of the second surface.

Two electronic control units are integrated into the control module provided in this application. The two electronic control units share one cooling plate, and heat dissipation effect is good. In addition, a volume of the control module is smaller, to adapt to a requirement of a small size scenario and facilitate installation. Besides, this ensures sealing performance and maintenance convenience of the circuit board, making the electronic control unit waterproof and dustproof, easy to be detached and assembled, and convenient to be maintained. It is ensured that the electronic control unit works efficiently and stably, and energy consumption and costs are reduced.

In a possible implementation, the control module further includes a first sealing structure, and the first sealing structure is located between the first housing and the first surface, and is configured to seal the first housing and the first surface. The first sealing structure is of a hollow ring shape, and the first accommodation space is sealed through the first sealing structure. In an implementation, the first sealing structure may be a sealing rubber strip. In an implementation, the first sealing structure is located at an edge of the first surface, so that a majority of the first surface is used as a bottom of the first accommodation space, thereby improving heat dissipation effect.

In an implementation, the first housing is connected to the first surface by using a bolt. The first housing and the first surface are detached and connected by using a disassembling bolt. In addition, the first sealing structure is used for sealing, to implement sealing and detachable connection between the first housing and the first surface. Besides, a compression degree of the first housing and the first surface may be adjusted, so that the first sealing structure is in interference fit with both the first housing and the first surface, thereby achieving better sealing effect. In this application, the first sealing structure is a sealing rubber strip, and the sealing rubber strip is not fastened to the first surface and the first housing. The first housing and the first surface are locked by using a bolt, and the sealing rubber strip is pressed tightly between the first housing and the first surface, to implement sealing between the first housing and the first surface. That is, the first housing and the first surface are detachably connected by using a bolt, and the first housing and the first surface are sealed through the first sealing structure. When the first circuit board needs to be detached for maintenance, the bolt may be first detached, and then the first housing is removed from the cooling plate, so that the first circuit board can be maintained.

In an implementation, a standard installation interface is used between the cooling plate and the first housing, so that one cooling plate adapts to different types of first housings.

In an implementation, the first housing and the first surface may also be connected in another manner such as buckling. In an implementation, the first sealing structure is fastened to the first housing, and then abuts against the first surface. A position of the first sealing structure is relatively fixed, and a sealing function can be implemented more stably. In an implementation, the first sealing structure may also be fastened to the first surface, and then abuts against the first housing. A position of the first sealing structure is relatively fixed, and a sealing function can be implemented more stably.

In an implementation, the first surface is provided with a groove recessed toward the second surface along the first direction. The first sealing structure is located in the groove. A boss is provided on a surface that is of the first housing and that is close to the first surface along the first direction. The boss presses the first sealing structure in the groove to implement sealing between the first housing and the first surface. The first sealing structure is in interference fit with both the groove and the boss. In an implementation, the first surface may alternatively be provided with a boss that protrudes toward the first housing along the first direction. A groove is provided on the surface that is of the first housing and that is close to the first surface along the first direction. The first sealing structure is located in the groove, and the boss presses the first sealing structure in the groove to implement sealing between the first housing and the first surface. A shape of a cross section of the first sealing structure may also be a circle, an ellipse, a square, or the like.

In this application, the first sealing structure is disposed. The first sealing structure is not fastened to the first housing and the first surface, or the first sealing structure is fastened to only the first housing or the first surface, so that the first housing and the first surface can be detachably connected in a sealed manner. When the first circuit board is faulty, the first circuit board can be completely detached from the first housing for maintenance without damaging the first housing and the first circuit board, thereby improving maintenance convenience of the first circuit board. In addition, the first sealing structure is used for sealing, and disassembly and assembly efficiency is high. Besides, the first sealing structure has specific elasticity and softness. Even if the first surface or the surface that is of the first housing and that is close to the first surface along the first direction is uneven, good sealing effect can also be achieved, and adaptability is strong.

In a possible implementation, the control module further includes a second sealing structure. The second sealing structure is located between the second housing and the second surface, and is configured to seal the second housing and the second surface. The second sealing structure is of a hollow ring shape, and the second accommodation space is sealed through the second sealing structure. In an implementation, the second sealing structure may be a sealing rubber strip. In an implementation, the second sealing structure is located at an edge of the second surface, so that a majority of the second surface is used as a bottom of the second accommodation space, thereby improving heat dissipation effect.

In an implementation, features such as a shape, a material, and a size of the second sealing structure may be the same as or different from those of the first sealing structure.

In an implementation, the second housing is connected to the second surface by using a bolt. The second housing and the second surface are detached and connected by using a disassembling bolt. In addition, the second sealing structure is used for sealing, to implement sealing and detachable connection between the second housing and the second surface. Besides, a compression degree of the second housing and the second surface may be adjusted, so that the second sealing structure is in interference fit with both the second housing and the second surface, thereby achieving better sealing effect. In this application, the second sealing structure is a sealing rubber strip, and the sealing rubber strip is not fastened to the second surface and the second housing. The second housing and the second surface are locked by using a bolt, and the sealing rubber strip is pressed tightly between the second housing and the second surface, to implement sealing between the second housing and the second surface. That is, the second housing and the second surface are detachably connected by using the bolt, and the second housing and the second surface are sealed through the second sealing structure. When the second circuit board needs to be detached for maintenance, the bolt may be first detached, and then the second housing is removed from the cooling plate, so that the second circuit board can be maintained.

In an implementation, a standard installation interface is used between the cooling plate and the second housing, so that one cooling plate adapts to different types of second housings.

In an implementation, the second housing and the second surface may also be connected in another manner such as buckling. In an implementation, the second sealing structure is fastened to the second housing, and then abuts against the second surface. A position of the second sealing structure is relatively fixed, and a sealing function can be implemented more stably. In an implementation, the second sealing structure may also be fastened to the second surface, and then abuts against the second housing. A position of the second sealing structure is relatively fixed, and a sealing function can be implemented more stably.

In an implementation, the second surface is provided with a groove recessed toward the first surface along the first direction. The second sealing structure is located in the groove. A boss is provided on a surface that is of the second housing and that is close to the second surface along the first direction. The boss presses the second sealing structure in the groove to implement sealing between the second housing and the second surface. The second sealing structure is in interference fit with both the groove and the boss. In an implementation, the second surface may alternatively be provided with a boss that protrudes toward the second housing along the first direction. A groove is provided on the surface that is of the second housing and that is close to the second surface along the first direction. The second sealing structure is located in the groove, and the boss presses the second sealing structure in the groove to implement sealing between the second housing and the second surface.

In this application, the second sealing structure is disposed. The second sealing structure is not fastened to the second housing and the second surface, or the second sealing structure is fastened to only the second housing or the second surface, so that the second housing and the second surface can be detachably connected in a sealed manner. When the second circuit board is faulty, the second circuit board can be completely detached from the second housing for maintenance without damaging the second housing and the second circuit board, thereby improving maintenance convenience of the second circuit board. In addition, the second sealing structure is used for sealing, and disassembly and assembly efficiency is high. Besides, the second sealing structure has specific elasticity and softness. Even if the second surface or the surface that is of the second housing and that is close to the second surface along the first direction is uneven, good sealing effect can also be achieved, and adaptability is strong.

In a possible implementation, the control module further includes a first connector. The first connector penetrates the first housing. Two ends of the first connector are respectively located inside and outside the first accommodation space. A third sealing structure is disposed on a periphery of the first connector. The third sealing structure is connected to the first housing to isolate the first accommodation space from the outside. The first connector is configured to implement information exchange between the first circuit board and the outside. The first connector is electrically connected to the first circuit board inside the first accommodation space, the first connector extends from the inside of the first accommodation space to the outside of the first accommodation space, and the first connector and the first housing are sealed through the third sealing structure.

In an implementation, the electronic control unit further includes a connector. That is, an entirety of the first circuit board, the first housing, and the first connector is referred to as the first electronic control unit. In an implementation, the first connector may be a CAN connector, an Ethernet connector, a camera connector, or the like. In an implementation, the control module may include a plurality of first connectors. The plurality of first connectors may be connectors of a same type, or may be connectors of different types. To enable the control module to adapt to various situations, a large quantity of or a plurality of types of first connectors may be preset, and then some of the first connectors are selected for use according to an actual requirement. In an implementation, the first connector may also be a standardized connector, and a quantity of the first connectors may be increased or decreased to adapt to requirements for a quantity of the first connectors in different situations.

In an implementation, the first housing includes a first enclosure frame and a first cover plate that is located on the first enclosure frame and that is away from the first surface. The first enclosure frame, the first cover plate, and the first surface enclose the first accommodation space. The first connector is disposed on the first enclosure frame.

In a possible implementation, a first hole in communication with the first accommodation space is provided on the first housing, the third sealing structure is adhesive, the first connector is fastened in the first hole through the adhesive, and one end of the first connector extends into the first accommodation space and is detachably connected to the first circuit board. The first hole is provided on the first enclosure frame, and the first connector is fastened to the first enclosure frame by dispensing the adhesive. In this case, the first circuit board and the first connector are disposed in a detachable connection, to ensure maintenance convenience of the first circuit board.

In an implementation, the first connector may alternatively be fastened to the first housing by welding and the like, or the first connector and the first housing are integrally formed.

In a possible implementation, the control module further includes a first connection board and a first circuit board connector disposed on the first connection board. The first connection board is fastened to the first connector. The first circuit board is detachably connected to the first connection board through the first circuit board connector. The first connection board is fastened to the first connector by welding or dispensing adhesive, and the first connector may alternatively be fastened to the first connection board by welding or dispensing adhesive. In this case, a manner of connecting the first connector to the first housing is not limited, and the first connector and the first housing are in a detachable connection or a nondetachable connection, which does not affect disassembly and assembly of the first circuit board.

In an implementation, the first connection board may be a common conductive plate, and no component is disposed on the first connection board, or the first connection board has only a few highly reliable passive components. In an implementation, the first circuit board connector may be a BTB connector.

In a possible implementation, the first circuit board is located on a side that is of the first circuit board connector and that is adjacent to the first surface. When the first circuit board is detached, because the first housing is detachably connected to the cooling plate through the first sealing structure, the first housing may be directly detached from the cooling plate, and then the first circuit board is pulled out in a direction along the first direction away from the first cover plate. Such a disassembly manner is convenient and does not damage the first circuit board.

In a possible implementation, the third sealing structure includes a first sealing rubber strip and a first protective cover. A first hole in communication with the first accommodation space is provided on the first housing. The first connector penetrates the first hole. One end of the first connector extends into the first accommodation space and is fastened to the first circuit board, and the other end of the first connector extends to the outside of the first accommodation space. The first protective cover covers one end that is of the first connector and that is away from the first circuit board. The first protective cover and a surface that is of the first housing and that is away from the first circuit board are sealed through the first sealing rubber strip.

One part of the first connector is located in the first accommodation space, and the other part of the first connector is located in the first protective cover. The first protective cover is detachably connected to the first housing in a sealed manner through the first sealing rubber strip. The first sealing rubber strip and the first protective cover are disposed to seal both the first accommodation space and a space in the first protective cover. In this case, the first connector is disposed in contact with the first housing, and the first connector and the first housing are not in a nondetachable connection. The first connector may be directly welded to the first circuit board. During disassembly, the first housing may be directly detached from the cooling plate, the first protective cover may be detached, and then the first circuit board and the first connector are detached from the first housing together.

In an implementation, the first sealing rubber strip may be fastened to the first housing in advance, and the first protective cover abuts against the first sealing rubber strip to implement sealing. In this case, the first sealing rubber strip may be completely located on the first enclosure frame, or may be partially located on the first enclosure frame and partially located on the first cover plate. In an implementation, the first sealing rubber strip is fastened to the first protective cover in advance, and the first sealing rubber strip abuts against the first housing to implement sealing. In an implementation, a cable is disposed at one end that is of the first connector and that is away from the first circuit board. A side that is of the first protective cover and that is away from the first circuit board is provided with openings opposite each other to allow the cable to pass through, and the cable and the openings may be sealed and fastened by dispensing adhesive.

A sealed connection manner between the first connector and the first housing provided in this application is simpler to implement and more operable.

In a possible implementation, the first housing includes a first enclosure frame and a first cover plate that is located on the first enclosure frame and that is away from the first surface. The first enclosure frame, the first cover plate, and the first surface enclose the first accommodation space. A fifth sealing structure is further disposed between the first enclosure frame and the first cover plate. The fifth sealing structure is located between the first enclosure frame and the first cover plate, and is detachably connected to the first enclosure frame and the first cover plate separately. The fifth sealing structure is configured to seal the first enclosure frame and the first cover plate.

The first enclosure frame is detachably connected to the first surface in a sealed manner. The first cover plate is located on a side that is of the first enclosure frame and that is away from the first surface along the first direction. In this application, the first cover plate is parallel or approximately parallel to the first surface. The fifth sealing structure is disposed, so that maintenance of the first circuit board is more convenient.

In an implementation, the control module further includes the first connection board and the first circuit board connector disposed on the first connection board. The first connection board is fastened to the first connector. The first circuit board is detachably connected to the first connection board through the first circuit board connector. The first circuit board is located on a side that is of the first circuit board connector and that is away from the first surface. When the first circuit board is detached, the first cover plate is directly removed, and then the first circuit board is pulled out in a direction along the first direction away from the cooling plate. Such a disassembly manner is convenient and does not damage the first circuit board, and the first housing does not need to be detached from the cooling plate.

In a possible implementation, the control module further includes a second connector. The second connector penetrates the second housing. Two ends of the second connector are respectively located inside and outside the second accommodation space. A fourth sealing structure is disposed on a periphery of the second connector. The fourth sealing structure is connected to the second housing to isolate the second accommodation space from the outside. The second connector is configured to implement information exchange between the second circuit board and the outside. The second connector is electrically connected to the second circuit board inside the second accommodation space, the second connector extends from the inside of the second accommodation space to the outside of the second accommodation space, and the second connector and the second housing are sealed through the fourth sealing structure.

In an implementation, the electronic control unit further includes a connector. That is, an entirety of the second circuit board, the second housing, and the second connector is referred to as the first electronic control unit. In an implementation, the second connector may be a CAN connector, an Ethernet connector, a camera connector, or the like. In an implementation, the control module may include a plurality of second connectors. The plurality of second connectors may be connectors of a same type, or may be connectors of different types. To enable the control module to adapt to various situations, a large quantity or a plurality of types of second connectors may be preset, and then some of the second connectors are selected for use according to an actual requirement. In an implementation, the second connector may also be a standardized connector, and a quantity of the second connectors may be increased or decreased to adapt to requirements for a quantity of the second connectors in different situations.

In an implementation, the second housing includes a second enclosure frame and a second cover plate that is located on the second enclosure frame and that is away from the first surface. The second enclosure frame, the second cover plate, and the first surface enclose the second accommodation space. The second connector is disposed on the second enclosure frame.

In a possible implementation, a second hole in communication with the second accommodation space is provided on the second housing, the fourth sealing structure is adhesive, the second connector is fastened in the second hole by dispensing the adhesive, and one end of the second connector extends into the second accommodation space and is detachably connected to the second circuit board. The second hole is provided on the second enclosure frame, and the second connector is fastened to the second enclosure frame by dispensing the adhesive. In this case, the second circuit board and the second connector are disposed in a detachable connection, to ensure maintenance convenience of the second circuit board.

In an implementation, the second connector may alternatively be fastened to the second housing by welding and the like, or the second connector and the second housing are integrally formed.

In a possible implementation, the control module further includes a second connection board and a second circuit board connector disposed on the second connection board. The second connection board is fastened to the second connector. The second circuit board is detachably connected to the second connection board through the second circuit board connector. The second connection board is fastened to the second connector by welding or dispensing adhesive, and the second connector may alternatively be fastened to the second connection board by welding or dispensing adhesive. In this case, a manner of connecting the second connector to the second housing is not limited, and the second connector and the second housing are in a detachable connection or a nondetachable connection, which does not affect disassembly and assembly of the second circuit board.

In an implementation, the second connection board may be a common conductive plate, and no component is disposed on the second connection board, or the second connection board has only a few highly reliable passive components. In an implementation, the second circuit board connector may be a BTB connector.

In a possible implementation, the second circuit board is located on a side that is of the second circuit board connector and that is adjacent to the second surface. When the second circuit board is detached, because the second housing is detachably connected to the cooling plate through the second sealing structure, the second housing may be directly detached from the cooling plate, and then the second circuit board is pulled out in a direction along the first direction away from the second cover plate. Such a disassembly manner is convenient and does not damage the second circuit board.

In a possible implementation, the fourth sealing structure includes a second sealing rubber strip and a second protective cover. A second hole in communication with the second accommodation space is provided on the second housing. The second connector penetrates the second hole. One end of the second connector extends into the second accommodation space and is fastened to the second circuit board, and the other end of the second connector extends to the outside of the second accommodation space. The second protective cover covers one end that is of the second connector and that is away from the second circuit board. The second protective cover and a surface that is of the second housing and that is away from the second circuit board are sealed through the second sealing rubber strip.

One part of the second connector is located in the second accommodation space, and the other part of the second connector is located in the second protective cover. The second protective cover is detachably connected to the second housing in a sealed manner through the second sealing rubber strip. The second sealing rubber strip and the second protective cover are disposed to seal both the second accommodation space and a space in the second protective cover. In this case, the second connector is disposed in contact with the second housing, and the second connector and the second housing are not in a nondetachable connection. The second connector may be directly welded to the second circuit board. During disassembly, the second housing may be directly detached from the cooling plate, the second protective cover may be detached, and then the second circuit board and the second connector are detached from the second housing together.

In an implementation, the second sealing rubber strip may be fastened to the second housing in advance, and the second protective cover abuts against the second sealing rubber strip to implement sealing. In this case, the second sealing rubber strip may be completely located on the first enclosure frame, or may be partially located on the first enclosure frame and partially located on the first cover plate. In an implementation, the second sealing rubber strip is fastened to the second protective cover in advance, and the second sealing rubber strip abuts against the second housing to implement sealing. In an implementation, a cable is disposed at one end that is of the second connector and that is away from the second circuit board. A side that is of the second protective cover and that is away from the second circuit board is provided with openings opposite each other to allow the cable to pass through, and the cable and the openings may be sealed and fastened by dispensing adhesive.

In a possible implementation, the first electronic control unit and the second electronic control unit are sealed and fastened to the cooling plate in different manners. For example, in the first electronic control unit, the first circuit board is detachably connected to the first connection board through the first circuit board connector, and the first connector is fastened to the first housing in a sealed manner by dispensing adhesive or welding. In the second electronic control unit, the second connector is fastened to the second circuit board by welding. The fourth sealing structure includes the second sealing rubber strip and the second protective cover. The second protective cover and the second housing are sealed through the second sealing rubber strip, so that both the second accommodation space and a space in the second protective cover are sealed.

A sealed connection manner between the second connector and the second housing provided in this application is simpler to implement and more operable.

In a possible implementation, the second housing includes a second enclosure frame and a second cover plate that is located on the second enclosure frame and that is away from the second surface. The second enclosure frame, the second cover plate, and the second surface enclose the second accommodation space. A sixth sealing structure is further disposed between the second enclosure frame and the second cover plate. The sixth sealing structure is located between the second enclosure frame and the second cover plate, and is detachably connected to the second enclosure frame and the second cover plate. The sixth sealing structure is configured to seal the second enclosure frame and the second cover plate. The second enclosure frame is detachably connected to the second surface in a sealed manner. The second cover plate is located on a side that is of the second enclosure frame and that is away from the second surface along the first direction. In this implementation, the second cover plate is parallel or approximately parallel to the second surface. The sixth sealing structure is disposed, so that maintenance of the second circuit board is more convenient.

In an implementation, the control module further includes a second connection board and a second circuit board connector disposed on the second connection board. The second connection board is fastened to the second connector. The second circuit board is detachably connected to the second connection board through the second circuit board connector. The second circuit board is located on a side that is of the second circuit board connector and that is away from the second surface. When the second circuit board is detached, the second cover plate is directly removed, and then the second circuit board is pulled out in a direction along the first direction away from the cooling plate. Such a disassembly manner is convenient and does not damage the second circuit board, and the first housing does not need to be detached from the cooling plate.

According to a second aspect, this application provides a heat dissipation system. The heat dissipation system includes a heat dissipation component and the control module according to any one of the foregoing implementations. The heat dissipation component is configured to dissipate heat for a cooling plate, so that the cooling plate cools a first circuit board and a second circuit board.

In an implementation, the heat dissipation component includes a cooling pipe and a pump. There is coolant inside the cooling pipe. The cooling plate is in communication with the cooling pipe. The pump is configured to drive the coolant to flow in the cooling pipe and the cooling plate, so that the cooling plate cools the first circuit board and the second circuit board.

In a process of circulation, the coolant can take away heat of the cooling plate, thereby reducing a temperature of the cooling plate. The pump provides power for circulation of the coolant. In an implementation, the heat dissipation system further includes a cooler, and the cooling plate is further provided with a liquid inlet and a liquid outlet. Under the action of the pump, the coolant circulates between the cooler and the cooling plate, and the heat of the cooling plate is transferred to the cooler. The cooler converts inflowing higher-temperature coolant into lower-temperature coolant and discharges the lower-temperature coolant. The lower-temperature coolant enters the cooling plate through the liquid inlet to cool the first circuit board and the second circuit board. The higher-temperature coolant in the cooling plate flows out to the cooler through the liquid outlet for cooling and further circulation.

In an implementation, the heat dissipation system may include one or more control modules.

According to a third aspect, this application provides an electronic device. The electronic device includes a device body and the heat dissipation system described above. The heat dissipation system is mounted on the device body.

According to a fourth aspect, this application provides a vehicle. The vehicle includes a vehicle frame and the heat dissipation system described above. The heat dissipation system is mounted on the vehicle frame.

In this application, two electronic control units are integrated into the control module. The cooling plate dissipates heat for the two electronic control units at the same time, so that a volume can be reduced and facilitate installation. In addition, the first housing and the second housing are detachably connected to the cooling plate in a sealed manner, thereby ensuring sealing performance of the circuit board. In addition, a detachable connection between the cooling plate and each of the first housing and the second housing ensures maintenance convenience of the circuit board, making the electronic control unit waterproof and dustproof, easy to be detached and assembled, and convenient to be maintained. This ensures that the electronic control unit works efficiently and stably.

### BRIEF DESCRIPTION OF DRAWINGS

To describe technical solutions in embodiments of this application more clearly, the following describes the accompanying drawings used in embodiments of this application.
FIG. 1 is a diagram of a structure of an electronic device according to an implementation of this application;
FIG. 2 is an exploded view of a control module according to an implementation of this application;
FIG. 3 is a sectional view of a control module according to an implementation of this application;
FIG. 4 is a diagram of a first housing, a second housing, and a cooling plate according to an implementation of this application;
FIG. 5 is a diagram of a first housing and a cooling plate according to an implementation of this application;
FIG. 6 is a sectional view of a control module according to an implementation of this application;
FIG. 7 is a sectional view of a control module according to an implementation of this application;
FIG. 8 is a sectional view of a control module according to an implementation of this application;
FIG. 9 is a sectional view of a control module according to an implementation of this application;
FIG. 10 is a diagram of a heat dissipation system according to an implementation of this application; and
FIG. 11 is a sectional view of a cooling plate in a control module, a first housing, and a second housing according to an implementation of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

Terms such as "first" and "second" in this specification are merely intended for a purpose of description, and shall not be understood as an indication or implication of relative importance or implicit indication of a quantity of indicated technical features. Therefore, a feature limited by "first" or "second" may explicitly or implicitly include one or more features. In the descriptions of this application, unless otherwise stated, "a plurality of" means two or more than two.

In addition, in this specification, position terms such as "top" and "bottom" are defined relative to positions of structures in the accompanying drawings. It should be understood that these position terms are relative concepts used for relative description and clarification, and may correspondingly change according to changes in the positions of the structures.

For ease of understanding, English abbreviations and related technical terms used in embodiments of this application are first explained and described below.

An electronic control unit (electronic control unit, ECU) is also referred to as a "driving computer" or an "on-board computer", and is a vehicle-specific microcomputer controller in terms of use.

CAN is an abbreviation for controller area network, that is, controller area network.

IP67 indicates a level of protection. IP is an abbreviation for Ingress Protection Rating (or International Protection code), and defines a protection capability of an interface against liquid and solid particles. IP67 indicates protection against dust ingress (complete protection against contact, and dust-tight) and protection against temporary immersion (waterproof).

This application provides a control module. The control module includes a cooling plate, a first housing, a first circuit board, a second housing, and a second circuit board. The cooling plate includes a first surface and a second surface that are arranged along a thickness direction. The first housing encloses a first accommodation space with the first surface. The second housing encloses a second accommodation space with the second surface. Both the first housing and the second housing are detachably connected to the cooling plate in a sealed manner. The first circuit board and the second circuit board are respectively located in the first accommodation space and the second accommodation space. A first chip and a first heat conduction structure are disposed on the first circuit board. The first heat conduction structure is disposed between the first chip and the first surface. The cooling plate dissipates heat for the first chip by using the first heat conduction structure. A second chip and a second heat conduction structure are disposed on the second circuit board. The cooling plate dissipates heat for the second chip by using the second heat conduction structure. In this application, two circuit boards in the control module share one cooling plate, and heat dissipation effect is good. In addition, a volume of the control module is smaller, to adapt to a requirement of a small size scenario and facilitate installation.

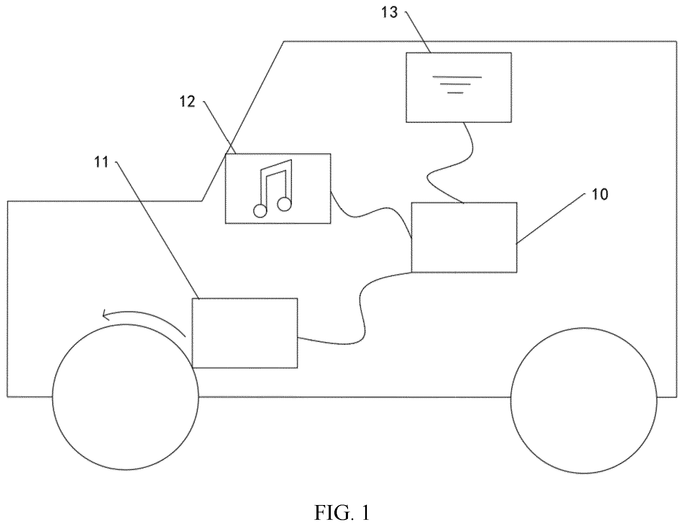

The control module in this application may be used in an electronic device. The electronic device includes a device body and the control module, and the control module is mounted on the device body. The electronic device includes a vehicle, a transportation device, and a robot. For example, when the electronic device is a vehicle, the control module may be an in-vehicle control module. The vehicle is used as an example of the electronic device for description below. With development of intelligent vehicle technologies, there are more in-vehicle electronic devices, such as a radar, a camera, a motor, an anti-lock braking system, a four-wheel drive system, an electronically controlled automatic transmission, an active suspension system, a supplementary restraint system, and a multi-directional adjustable electronically controlled seat. These electronic devices are usually connected to an electronic control unit. FIG. 1 is a diagram of a structure of an electronic device according to an implementation of this application. A control module 10 in FIG. 1 may include one or more electronic control units, and each electronic control unit may be configured to control at least one of an autonomous driving system 11, an in-vehicle entertainment system 12, and a communication system 13.

The electronic control unit (ECU) is a "driving computer" of a vehicle, and is configured to collect, calculate, process, and determine information of various sensors, and output operation instructions. The electronic control unit usually includes a microprocessor (CPU), a memory (a ROM, or a RAM), an input/output interface (I/O), an analog-to-digital converter (A/D), and large-scale integrated circuits such as a shaping circuit and a drive circuit.

When the electronic control unit works, components of the electronic control unit generate heat. Especially with the development of vehicles, the electronic control unit needs to process an increasingly large amount of data, and a requirement for computing power of the electronic control unit also constantly increases. As a result, there are more electronic components on a circuit board inside the electronic control unit. Circuit integration increases exponentially, and a working load of the electronic control unit increases greatly, resulting in a significant increase in heat generation. In addition, to shorten a length of a cable between different electronic control units and reduce computing power redundancy of electronic control units, the electronic control units are gradually centralized, leading to a more prominent problem of difficulty in heat dissipation. In addition, the electronic control unit is usually mounted in an engine compartment, and a high-temperature environment in the compartment affects running of an electronic component of the electronic control unit, resulting in a higher temperature of the electronic control unit.

High temperature affects performance and stability of the electronic control unit. If the electronic control unit is not cooled in a timely manner, the electronic control unit may operate slowly, and in severe cases, component burnout may even occur, affecting driving safety. To enable the electronic control unit to work efficiently and stably in a case of a significant increase in heat generation, it is necessary to improve a heat dissipation capability of the electronic control unit and enhance protection for the electronic control unit. The control module provided in this application has a good heat dissipation capability, and two electronic control units share a cooling plate for heat dissipation, so that a volume can be further reduced and installation is easier.

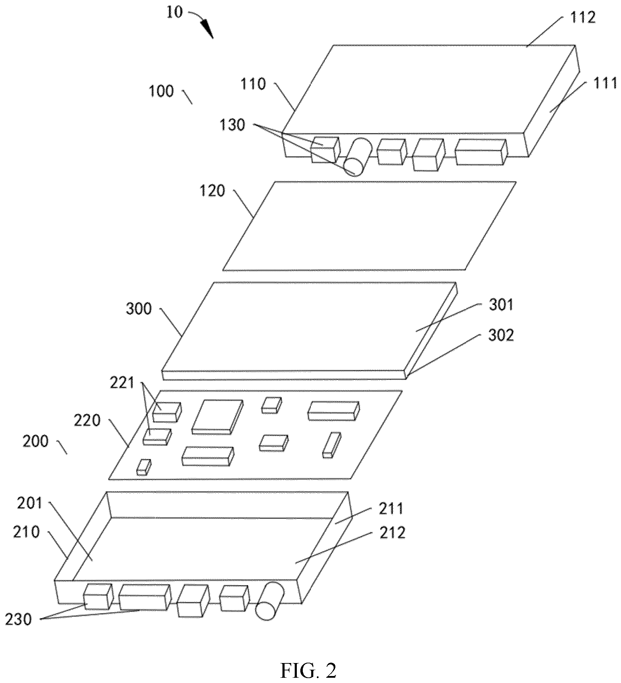

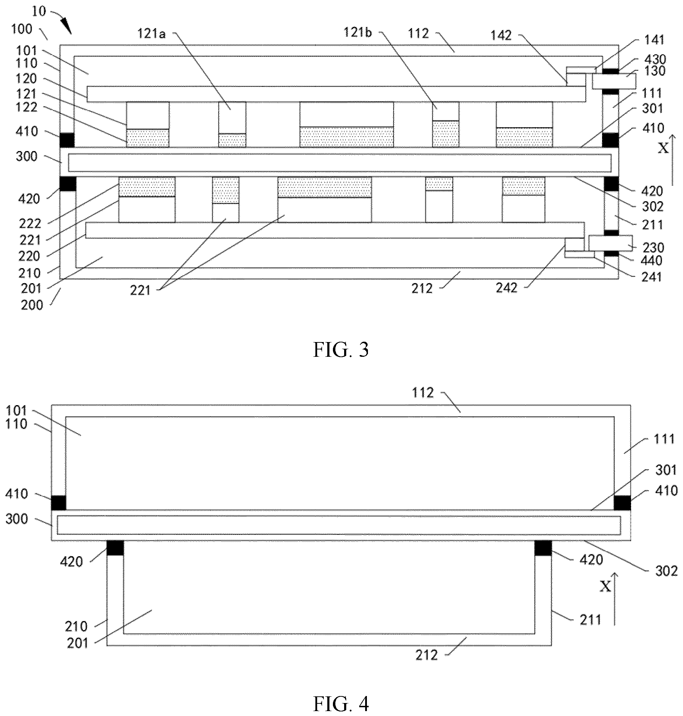

FIG. 2 is an exploded view of a control module 10 according to an implementation of this application. FIG. 3 is a sectional view of a control module 10 according to an implementation of this application. A first embodiment of this application provides a control module 10. The control module includes a cooling plate 300, a first housing 110, a first circuit board 120, a second housing 210, and a second circuit board 220. The cooling plate 300 includes a first surface 301 and a second surface 302 that are arranged along a thickness direction. The first housing 110 is located on a same side as the first surface 301 and encloses a first accommodation space 101 (as shown in FIG. 3) with the first surface 301. The first housing 110 is detachably connected to the cooling plate 300 in a sealed manner. The first circuit board 120 is located in the first accommodation space 101 and is detachably connected to the first housing 110. A first chip 121 is disposed on a side that is of the first circuit board 120 and that faces the first surface 301. A first heat conduction structure 122 is disposed between the first chip 121 and the first surface 301. The cooling plate 300 dissipates heat for the first chip 121 by using the first heat conduction structure 122. The second housing 210 is located on a same side as the second surface 302 and encloses a second accommodation space 201 with the second surface 302. The second housing 210 is detachably connected to the cooling plate 300 in a sealed manner. The second circuit board 220 is located in the second accommodation space 201 and is detachably connected to the second housing 210. A second chip 221 is disposed on a side that is of the second circuit board 220 and that faces the second surface 302. A second heat conduction structure 222 is disposed between the second chip 221 and the second surface 302. The cooling plate 300 dissipates heat for the second chip 221 by using the second heat conduction structure 222.

The cooling plate 300 is also referred to as a cooling-down plate. The cooling plate 300 can maintain a low temperature, and is configured to cool the first chip 121 and the second chip 221, or may be configured to cool the first circuit board 120 and the second circuit board 220. In an implementation, a temperature of the cooling plate 300 may be adjusted based on heat generation statuses of the first chip 121 and the second chip 221, to achieve good cooling effect. A thickness direction of the cooling plate 300 is a first direction X, and the first surface 301 and the second surface 302 of the cooling plate 300 are arranged along the first direction X. In this implementation, the cooling plate 300 is a cuboid, the first direction X is the thickness direction of the cooling plate 300, and the first surface 301 and the second surface 302 are two surfaces with largest areas of the cooling plate 300, so that high cooling efficiency is ensured and a volume of the cooling plate 300 is reduced.

In an implementation, the cooling plate 300 is of a hollow structure, and there is coolant inside the cooling plate 300. The cooling plate 300 is further provided with a liquid inlet and a liquid outlet (not shown in the figure). Heat exchange is implemented for the first chip 121 and the second chip 221 by using the coolant, to cool the first chip 121 and the second chip 221. In another implementation, the cooling plate 300 may alternatively be in another shape. Specifically, a shape of the cooling plate 300 may be adjusted based on the first housing 110, the second housing 210, and a surrounding environment. In some implementations, the cooling plate 300 is an air-cooled cooling plate, and a fan is disposed in the cooling plate 300. The fan drives air circulation inside and outside the cooling plate 300, to implement heat exchange and cool the first chip 121 and the second chip 221.

In this implementation, an entirety of the circuit board and the housing is referred to as an electronic control unit. To be specific, in this implementation, the first circuit board 120 and the first housing 110 may be referred to as a first electronic control unit 100, the second circuit board 220 and the second housing 210 may be referred to as a second electronic control unit 200, and the first electronic control unit 100 and the second electronic control unit 200 each may be configured to control an autonomous driving system 11, an in-vehicle entertainment system 12, a communication system 13, and the like. In an implementation, the first circuit board 120 may also be separately referred to as a first electronic control unit 100, and the second circuit board 220 may be referred to as a second electronic control unit 200.

In an implementation, the first electronic control unit 100 is configured to control the autonomous driving system 11 (as shown in FIG. 1 and FIG. 3). After collecting a signal, the first circuit board 120 learns of information about a current working condition of a vehicle, automatically plans a driving route, and intelligently controls the vehicle to travel on a preset driving route. In an implementation, the second electronic control unit 200 is configured to control the in-vehicle entertainment system 12, to implement media playing, gesture recognition, facial recognition, driving behavior monitoring, 360-degree panoramic image, local voice recognition, interaction with a dashboard or another screen, and the like, thereby meeting a driving experience requirement of a driver. In an implementation, the first electronic control unit 100 or the second electronic control unit 200 may alternatively be configured to control the communication system 13, to implement vehicle-to-vehicle communication and vehicle-to-infrastructure communication. For example, a road traveling condition of the vehicle and information about turning, overtaking, decelerating, lane changing, and the like of the vehicle are indicated through communication between vehicles. Alternatively, through communication between the vehicle and a communication base station, an accurate position is obtained or road condition information is obtained or propagated, to prevent an accident. In an implementation, the first electronic control unit 100 and the second electronic control unit 200 may be configured to control other functional systems or control a plurality of functional systems according to requirements, or the first electronic control unit 100 and the second electronic control unit 200 may coordinately control a same functional system.

The first circuit board 120, the second circuit board 220, and the cooling plate are disposed in parallel or approximately in parallel. The first chip 121 is fastened to the first circuit board 120 and is electrically connected to the first circuit board 120. One or more first chips 121 may be disposed on the first circuit board 120. Functions of the plurality of first chips 121 may be the same or may be different. The second chip 221 is fastened to the second circuit board 220 and is electrically connected to the second circuit board 220. One or more second chips 221 may be disposed on the second circuit board 220. Functions of the plurality of first chips 121 may be the same or may be different. In addition, quantities and functions of the second chips 221 and the first chips 121 may be the same or may be different. This is not limited in this application.

In a vehicle traveling process, a heat source in the control module 10 is mainly heat generated by the one or more first chips 121 and the one or more second chips 221. Therefore, heat dissipation is directly performed on the first chip 121 and the second chip 221, to cool the first electronic control unit 100 and the second electronic control unit 200. When the first chip 121 and the second chip 221 are directly in contact with the cooling plate 300, heat dissipation effect is not good. In addition, if different first chips 121 or different second chips 221 have different thicknesses in the first direction X, for example, the first chip 121a and the first chip 121b in FIG. 3, it is difficult for a chip with a small thickness to be attached to the cooling plate 300. Consequently, some chips cannot achieve good heat dissipation effect. However, in this implementation, the first heat conduction structure 122 is added on a side that is of the first chip 121 and that is away from the first circuit board 120 along the first direction X, and the second heat conduction structure 222 is added on a side that is of the second chip 221 and that is away from the second circuit board 220 along the first direction X. In this way, the first heat conduction structure 122 and the second heat conduction structure 222 are disposed to fill an air gap between the chip and the cooling plate 300, and the heat conduction structures (122, 222) can cover an uneven surface of the chip, to increase a heat dissipation area of the chip, and then heat of the chip can be better conducted to the cooling plate 300 for heat dissipation. This can improve efficiency and a service life of the electronic control unit. In addition, the heat conduction structures (122, 222) are disposed, so that chips of different thicknesses can be indirectly in contact with the cooling plate 300, and heat dissipation is implemented by using the cooling plate 300. Still further, the first heat conduction structure 122 may also be configured to support the first chip 121, and the second heat conduction structure 222 may also be configured to support the second chip 221, so that structural strength of the first circuit board 120 and the second circuit board 220 is improved.

In an implementation, the first heat conduction structure 122 and the second heat conduction structure 222 have features such as flexibility and elasticity. In this way, the first heat conduction structure 122 can cover all or a part of a surface that is of the first chip 121 and that is away from the first circuit board 120 along the first direction X, and the second heat conduction structure 222 can cover all or a part of a surface that is of the second chip 221 and that is away from the second circuit board 220 along the first direction X, so that heat dissipation can be better implemented on the first chip 121 and the second chip 221. In an implementation, when there is a problem of high temperature in a part that is of the first circuit board 120 or the second circuit board 220 and on which no chip is disposed, a heat conduction structure may also be added at a corresponding position, to transfer heat at the position to the cooling plate 300 for heat dissipation by using the heat conduction structure.

In this implementation, the first surface 301 and the second surface 302 of the cooling plate 300 are fully used to cool the first chip 121 and the second chip 221 respectively, so that energy consumption can be reduced. In addition, in comparison with an implementation in which only one cooling plate is used to cool one electronic control unit, in this implementation, one cooling plate 300 can be used to cool two electronic control units, so that a volume of the control module 10 is smaller, to adapt to a requirement of a small size scenario and facilitate installation.

The first housing 110 is configured to protect the first circuit board 120 (as shown in FIG. 3), and prevent the first circuit board 120 from being damaged due to collision with an external component. The first housing 110 and the first surface 301 jointly enclose the first accommodation space 101. The first accommodation space 101 is a sealed space. In this way, the first circuit board 120 may be sealed and isolated from an external environment, so that the first circuit board 120 is dustproof and waterproof. In this implementation, a sealing level of the first circuit board 120 may further reach IP67 or higher. The first accommodation space 101 may also prevent external water vapor from entering the first accommodation space 101 and condensing into condensate water due to an excessively low temperature, and the condensate water falls on the first circuit board 120, resulting in damage to the first circuit board 120. In addition, the cooling plate 300 implements a cooling function, and serves as a part to enclose the first accommodation space 101, implementing full utilization of the cooling plate 300. Additionally, the first heat conduction structure 122 is directly attached to the cooling plate 300, thereby achieving better heat dissipation effect. The cooling plate 300 may also cool air in the first accommodation space 101 to reduce a temperature of the first circuit board 120. In an implementation, desiccant is further placed in the first accommodation space 101, and is used to remove moisture in the first accommodation space 101. This ensures that the first accommodation space 101 is in a dry state, and prevents the moisture in the first accommodation space 101 from condensing onto the first circuit board 120 due to an excessively low temperature, resulting in damage to the first circuit board 120. If the first accommodation space 101 is not a sealed space, external water vapor is likely to penetrate into the first accommodation space 101, the desiccant is likely to be inactive. Consequently, frequent replacement of the desiccant also leads to high costs, which is time-consuming and labor-consuming. In this implementation, the first circuit board 120 can be better protected from water vapor by disposing the first accommodation space 101 as a sealed space and using the desiccant.

A detachable connection means that two interconnected components can be separated without being damaged. For example, the first housing 110 is detachably connected to the cooling plate 300, which means that the first housing 110 is fastened relative to the cooling plate 300 during normal use, and when maintenance is required, the first housing 110 and the cooling plate 300 can be separated, but the first housing 110 or the cooling plate 300 is not damaged. Because the first housing 110 is detachably connected to the cooling plate 300, and the first circuit board 120 is detachably connected to the first housing 110, when the first circuit board 120 is faulty, the first circuit board 120 can be completely detached from the first housing 110 for maintenance without damaging the first housing 110 and the first circuit board 120. This improves maintenance convenience of the first circuit board 120. Alternatively, when the first circuit board 120 needs to be replaced, the old first housing 110 may be reused to reduce costs. In addition, when the first housing 110 is damaged, only the first housing 110 may be replaced, and the first circuit board 120 may be detached and assembled to a new first housing 110.

The second housing 210 is configured to protect the second circuit board 220 (as shown in FIG. 3), and prevent the second circuit board 220 from being damaged due to collision with an external component. The second housing 210 and the second surface 302 jointly enclose the second accommodation space 201. The second accommodation space 201 is a sealed space. In this way, the second circuit board 220 may be sealed and isolated from an external environment, so that the second circuit board 220 is dustproof and waterproof. In this implementation, a sealing level of the second circuit board 220 may further reach IP67 or higher. The second accommodation space 201 may also prevent external water vapor from entering the second accommodation space 201 and condensing onto the second circuit board 220 due to an excessively low temperature, resulting in damage to the second circuit board 220. In addition, the cooling plate 300 implements a cooling function, and serves as a part to enclose the second accommodation space 201, implementing full utilization of the cooling plate 300. Additionally, the second heat conduction structure 222 is directly attached to the cooling plate 300, thereby achieving better heat dissipation effect. The cooling plate 300 may also cool air in the second accommodation space 201 to reduce a temperature of the second circuit board 220. Desiccant may also be placed in the second accommodation space 201, and is used to remove moisture in the second accommodation space 201. Because the second housing 210 is detachably connected to the cooling plate 300, and the second circuit board 220 is detachably connected to the second housing 210, when the second circuit board 220 is faulty, the second circuit board 220 can be completely detached from the second housing 210 for maintenance without damaging the second housing 210 and the second circuit board 220. This improves maintenance convenience of the second circuit board 220. Alternatively, when the second circuit board 220 needs to be replaced, the old second housing 210 may be reused to reduce costs. In addition, when the second housing 210 is damaged, only the second housing 210 may be replaced, and the second circuit board 220 may be detached and assembled to a new second housing 210.

In an implementation, the second housing 210 and the first housing 110 are equal in size and shape (as shown in FIG. 3), and orthographic projections of the second housing 210 and the first housing 110 on the cooling plate 300 exactly cover surfaces of the cooling plate 300, so that utilization of the cooling plate 300 is maximized. In another implementation, there is also a case in which the second housing 210 and the first housing 110 have different sizes (as shown in FIG. 4). This is not limited in this application. For example, an orthographic projection of the first housing 110 on the cooling plate 300 is located in the first surface 301, or an orthographic projection area of the first housing 110 on the cooling plate 300 is less than an area of the first surface 301. An orthographic projection of the second housing 210 on the cooling plate 300 is located in the second surface 302, or an orthographic projection area of the second housing 210 on the cooling plate 300 is less than an area of the second surface 302. For example, the orthographic projection area of the first housing 110 on the cooling plate 300 is greater than the area of the first surface 301, and the orthographic projection area of the second housing 210 on the cooling plate 300 is greater than the area of the second surface 302.

Two electronic control units (100, 200) are integrated into the control module 10 provided in this application. The two electronic control units share one cooling plate, and heat dissipation effect is good. In addition, a volume of the control module 10 is smaller, to adapt to a requirement of a small size scenario and facilitate installation. Besides, this ensures sealing performance and maintenance convenience of the circuit board, making the electronic control unit waterproof and dustproof, easy to be detached and assembled, and convenient to be maintained. It is ensured that the electronic control unit works efficiently and stably, and energy consumption and costs are reduced.

In a possible implementation, the control module 10 further includes a first sealing structure 410 (as shown in FIG. 3). The first sealing structure 410 is located between the first housing 110 and the first surface 301, and is configured to seal the first housing 110 and the first surface 301. The first sealing structure 410 is of a hollow ring shape, and the first accommodation space 101 is sealed through the first sealing structure 410. In an implementation, the first sealing structure 410 may be a sealing rubber strip. In an implementation, the first sealing structure 410 is located at an edge of the first surface 301, so that a majority of the first surface 301 is used as a bottom of the first accommodation space 101, thereby improving heat dissipation effect.

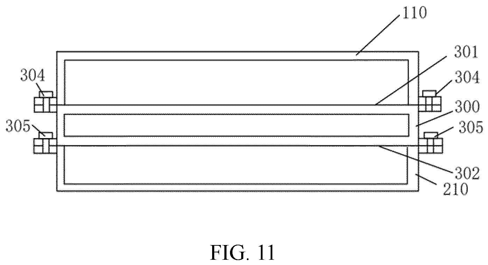

In an implementation, the first housing 110 is connected to the first surface 301 by using a bolt (as shown in FIG. 11). The first housing 110 and the first surface 301 are detached and connected by using a disassembling bolt 304. In addition, the first sealing structure 410 is used for sealing, to implement sealing and detachable connection between the first housing 110 and the first surface 301. Besides, a compression degree of the first housing 110 and the first surface 301 may be adjusted, so that the first sealing structure 410 is in interference fit with both the first housing 110 and the first surface 301, thereby achieving better sealing effect.

In this implementation, the first sealing structure 410 is a sealing rubber strip, and the sealing rubber strip is not fastened to the first surface 301 and the first housing 110. The first housing 110 and the first surface 301 are locked by using a bolt, and the sealing rubber strip is pressed tightly between the first housing 110 and the first surface 301, to implement sealing between the first housing 110 and the first surface 301. That is, the first housing 110 and the first surface 301 are detachably connected by using the bolt, and the first housing 110 and the first surface 301 are sealed through the first sealing structure 410. When the first circuit board 120 needs to be detached for maintenance, the bolt may be first detached, and then the first housing 110 is removed from the cooling plate 300, so that the first circuit board 120 can be maintained.

In an implementation, a standard installation interface is used between the cooling plate 300 and the first housing 110, so that one cooling plate 300 adapts to different types of first housings 110.

In an implementation, the first housing 110 and the first surface 301 may also be connected in another manner such as buckling. In an implementation, the first sealing structure 410 is fastened to the first housing 110, and then abuts against the first surface 301. A position of the first sealing structure 410 is relatively fixed, and a sealing function can be implemented more stably. In an implementation, the first sealing structure 410 may also be fastened to the first surface 301, and then abuts against the first housing 110. A position of the first sealing structure 410 is relatively fixed, and a sealing function can be implemented more stably.

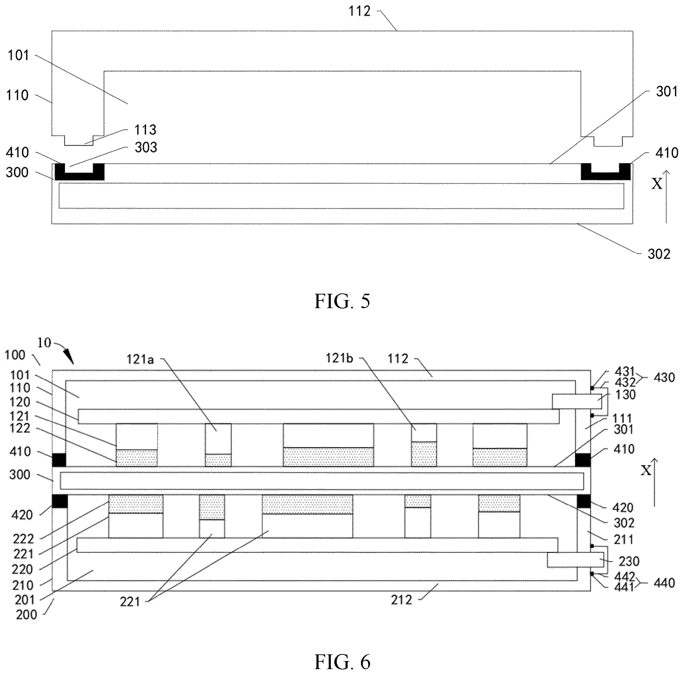

In an implementation, the first surface 301 is provided with a groove 303 (as shown in FIG. 5) recessed toward the second surface 302 along the first direction X. The first sealing structure 410 is located in the groove 303. A boss 113 is provided on a surface that is of the first housing 110 and that is close to the first surface 301 along the first direction X. The boss 113 presses the first sealing structure 410 in the groove 303 to implement sealing between the first housing 110 and the first surface 301. The first sealing structure 410 is in interference fit with both the groove 303 and the boss 113. In an implementation, the first surface 301 may alternatively be provided with a boss that protrudes toward the first housing 110 along the first direction X. A groove is provided on the surface that is of the first housing 110 and that is close to the first surface 301 along the first direction X. The first sealing structure 410 is located in the groove, and the boss presses the first sealing structure 410 in the groove to implement sealing between the first housing 110 and the first surface 301. A shape of a cross section of the first sealing structure 410 is not limited to the shape shown in FIG. 5, and the shape of the cross section of the first sealing structure 410 may also be a circle, an ellipse, a square, or the like.

If the first housing 110 and the first surface 301 are sealed by welding or dispensing adhesive, the first housing 110 and the first surface 301 are connected in a nondetachable manner. When the first circuit board 120 is faulty, the first housing 110 needs to be damaged to remove the first circuit board 120 for maintenance. In a removal process, the first circuit board 120 is also prone to further damage. In addition, when the first surface 301 or the surface that is of the first housing 110 and that is close to the first surface 301 along the first direction X is uneven, a sealing mode of welding or dispensing adhesive is difficult to implement, which is prone to incomplete sealing. Therefore, the sealing mode cannot be used in various scenarios.

In this implementation, the first sealing structure 410 is disposed. The first sealing structure 410 is not fastened to the first housing 110 and the first surface 301, or the first sealing structure 410 is fastened to only the first housing 110 or the first surface 301, so that the first housing 110 and the first surface 301 can be detachably connected in a sealed manner. When the first circuit board 120 is faulty, the first circuit board 120 can be completely detached from the first housing 110 for maintenance without damaging the first housing 110 and the first circuit board 120, thereby improving maintenance convenience of the first circuit board 120. In addition, the first sealing structure 410 is used for sealing, and disassembly and assembly efficiency is high. Besides, the first sealing structure 410 has specific elasticity and softness. Even if the first surface 301 or the surface that is of the first housing 110 and that is close to the first surface 301 along the first direction X is uneven, good sealing effect can also be achieved, and adaptability is strong.

In a possible implementation, the control module 10 further includes a second sealing structure 420 (as shown in FIG. 3). The second sealing structure 420 is located between the second housing 210 and the second surface 302, and is configured to seal the second housing 210 and the second surface 302. The second sealing structure 420 is of a hollow ring shape, and the second accommodation space 201 is sealed through the second sealing structure 420. In an implementation, the second sealing structure 420 may be a sealing rubber strip. In an implementation, the second sealing structure 420 is located at an edge of the second surface 302, so that a majority of the second surface 302 is used as a bottom of the second accommodation space 201, thereby improving heat dissipation effect.

In an implementation, features such as a shape, a material, and a size of the second sealing structure 420 may be the same as or different from those of the first sealing structure 410.

In an implementation, the second housing 210 is connected to the second surface 302 by using a bolt. The second housing 210 and the second surface 302 are detached and connected by using a disassembling bolt 305 (as shown in FIG. 11). In addition, the second sealing structure 420 is used for sealing, to implement sealing and detachable connection between the second housing 210 and the second surface 302. Besides, a compression degree of the second housing 210 and the second surface 302 may be adjusted, so that the second sealing structure 420 is in interference fit with both the second housing 210 and the second surface 302, thereby achieving better sealing effect. In this implementation, the second sealing structure 420 is a sealing rubber strip, and the sealing rubber strip is not fastened to the second surface 302 and the second housing 210. The second housing 210 and the second surface 302 are locked by using a bolt, and the sealing rubber strip is pressed tightly between the second housing 210 and the second surface 302, to implement sealing between the second housing 210 and the second surface 302. That is, the second housing 210 and the second surface 302 are detachably connected by using the bolt, and the second housing 210 and the second surface 302 are sealed through the second sealing structure 420. When the second circuit board 220 needs to be detached for maintenance, the bolt may be first detached, and then the second housing 210 is removed from the cooling plate 300, so that the second circuit board 220 can be maintained.

In an implementation, a standard installation interface is used between the cooling plate 300 and the second housing 210, so that one cooling plate 300 adapts to different types of second housings 210.

In an implementation, the second housing 210 and the second surface 302 may also be connected in another manner such as buckling. In an implementation, the second sealing structure 420 is fastened to the second housing 210, and then abuts against the second surface 302. A position of the second sealing structure 420 is relatively fixed, and a sealing function can be implemented more stably. In an implementation, the second sealing structure 420 may also be fastened to the second surface 302, and then abuts against the second housing 210. A position of the second sealing structure 420 is relatively fixed, and a sealing function can be implemented more stably.

In an implementation, the second surface 302 is provided with a groove recessed toward the first surface 301 along the first direction X. The second sealing structure 420 is located in the groove. A boss is provided on a surface that is of the second housing 210 and that is close to the second surface 302 along the first direction X. The boss presses the second sealing structure in the groove to implement sealing between the second housing 210 and the second surface 302. The second sealing structure 420 is in interference fit with both the groove and the boss. In an implementation, the second surface 302 may alternatively be provided with a boss that protrudes toward the second housing 210 along the first direction X. A groove is provided on the surface that is of the second housing 210 and that is close to the second surface 302 along the first direction X. The second sealing structure 420 is located in the groove, and the boss presses the second sealing structure 420 in the groove to implement sealing between the second housing 210 and the second surface 302.

If the second housing 210 and the second surface 302 are sealed by welding or dispensing adhesive, the second housing 210 and the second surface 302 are connected in a nondetachable manner. When the second circuit board 220 is faulty, the second housing 210 needs to be damaged to remove the second circuit board 220 for maintenance. In a removal process, the second circuit board 220 is also prone to further damage. In addition, when the second surface 302 or the surface that is of the second housing 210 and that is close to the second surface 302 along the first direction X is uneven, a sealing mode of welding or dispensing adhesive is difficult to implement, which is prone to incomplete sealing. Therefore, the sealing mode cannot be used in various scenarios.

In this implementation, the second sealing structure 420 is disposed. The second sealing structure 420 is not fastened to the second housing 210 and the second surface 302, or the second sealing structure 420 is fastened to only the second housing 210 or the second surface 302, so that the second housing 210 and the second surface 302 can be detachably connected in a sealed manner. When the second circuit board 220 is faulty, the second circuit board 220 can be completely detached from the second housing 210 for maintenance without damaging the second housing 210 and the second circuit board 220, thereby improving maintenance convenience of the second circuit board 220. In addition, the second sealing structure 420 is used for sealing, and disassembly and assembly efficiency is high. Besides, the second sealing structure 420 has specific elasticity and softness. Even if the second surface 302 or the surface that is of the second housing 210 and that is close to the second surface 302 along the first direction X is uneven, good sealing effect can also be achieved, and adaptability is strong.

In a possible implementation, the control module 10 further includes a first connector 130 (as shown in FIG. 3). The first connector 130 penetrates the first housing 110. Two ends of the first connector 130 are respectively located inside and outside the first accommodation space 101. A third sealing structure 430 is disposed on a periphery of the first connector 130. The third sealing structure 430 is connected to the first housing 110 to isolate the first accommodation space 101 from the outside. The first connector 130 is configured to implement information exchange between the first circuit board 120 and the outside. The first connector 130 is electrically connected to the first circuit board 120 inside the first accommodation space 101, the first connector 130 extends from the inside of the first accommodation space 101 to the outside of the first accommodation space 101, and the first connector 130 and the first housing 110 are sealed through the third sealing structure 430.

In an implementation, the electronic control unit further includes a connector. That is, an entirety of the first circuit board 120, the first housing 110, and the first connector 130 is referred to as the first electronic control unit 100. In an implementation, the first connector 130 may be a CAN connector, an Ethernet connector, a camera connector, or the like. In an implementation, the control module 10 may include a plurality of first connectors 130. The plurality of first connectors 130 may be connectors of a same type, or may be connectors of different types. To enable the control module 10 to adapt to various situations, a large quantity of or a plurality of types of first connectors 130 may be preset, and then some of the first connectors 130 are selected for use according to an actual requirement. In an implementation, the first connector 130 may also be a standardized connector, and a quantity of the first connectors 130 may be increased or decreased to adapt to requirements for a quantity of the first connectors 130 in different situations.

In an implementation, the first housing 110 includes a first enclosure frame 111 and a first cover plate 112 (as shown in FIG. 3) that is located on the first enclosure frame 111 and that is away from the first surface 301. The first enclosure frame 111, the first cover plate 112, and the first surface 301 enclose the first accommodation space 101. The first connector 130 is disposed on the first enclosure frame 111.

Because an outer surface of the first connector 130 is usually in an irregular shape, if the third sealing structure 430 is a sealing rubber strip and the first connector 130 is directly connected to the first housing 110 in a sealed manner through the sealing rubber strip, a shape of the sealing rubber strip needs to be attached to the outer surface of the first connector 130. That is, the shape of the sealing rubber strip also needs to be an irregular shape. This implementation is feasible, but is inconvenient. Therefore, to resolve a sealing problem between the first connector 130 and the first housing 110, two implementations are provided in this application. First, the first connector 130 is fastened and sealed on the first housing 110 by dispensing adhesive or welding (as shown in FIG. 3). In this case, to ensure maintenance convenience of the first circuit board 120, the first circuit board 120 and the first connector 130 are disposed in a detachable connection, to ensure sealing performance of the first accommodation space 101 and convenience of disassembly and assembly of the first circuit board 120. Second, a first protective cover 432 with a more regular outer surface is disposed on an outer side of the first connector 130 (as shown in FIG. 6). Then, a first sealing rubber strip 431 is disposed to implement sealing of an entirety of the first connector 130 and the first protective cover 432 with the first housing 110. In this case, the first connector 130 is in a detachable connection relationship with the first housing 110. If the first circuit board 120 is in a nondetachable connection with the first connector 130, an entirety of the first circuit board 120 and the first connector 130 may be detached for maintenance when the first circuit board 120 is maintained.

A sealed connection manner between the first connector 130 and the first housing 110 provided in this application is simpler to implement and more operable. For details, refer to the following descriptions.

Refer to FIG. 3. In a possible implementation, a first hole (not shown in the figure) in communication with the first accommodation space 101 is provided on the first housing 110, the third sealing structure 430 is adhesive, the first connector 130 is fastened in the first hole through the adhesive, and one end of the first connector 130 extends into the first accommodation space 101 and is detachably connected to the first circuit board 120. In this implementation, the first hole is provided on the first enclosure frame 111, and the first connector 130 is fastened to the first enclosure frame 111 by dispensing the adhesive. In this case, the first circuit board 120 and the first connector 130 are disposed in a detachable connection, to ensure maintenance convenience of the first circuit board 120.

In an implementation, the first connector 130 may alternatively be fastened to the first housing 110 by welding and the like, or the first connector 130 and the first housing 110 are integrally formed.

In a possible implementation, the control module 10 further includes a first connection board 141 and a first circuit board connector 142 disposed on the first connection board 141. The first connection board 141 is fastened to the first connector 130. The first circuit board 120 is detachably connected to the first connection board 141 through the first circuit board connector 142. The first connection board 141 is fastened to the first connector 130 by welding or dispensing adhesive, and the first connector 130 may alternatively be fastened to the first connection board 141 by welding or dispensing adhesive. In this case, a manner of connecting the first connector 130 to the first housing 110 is not limited, and the first connector 130 and the first housing 110 are in a detachable connection or a nondetachable connection, which does not affect disassembly and assembly of the first circuit board 120.

In an implementation, the first connection board 141 may be a common conductive plate, and no component is disposed on the first connection board 141, or the first connection board 141 has only a few highly reliable passive components. In an implementation, the first circuit board connector 142 may be a BTB connector (namely, board-to-board Connectors).

In a possible implementation, the first circuit board 120 is located on a side that is of the first circuit board connector 142 and that is adjacent to the first surface 301. When the first circuit board 120 is detached, because the first housing 110 is detachably connected to the cooling plate 300 through the first sealing structure 410, the first housing 110 may be directly detached from the cooling plate 300, and then the first circuit board 120 is pulled out in a direction along the first direction X away from the first cover plate 112. Such a disassembly manner is convenient and does not damage the first circuit board 120.

FIG. 6 is a sectional view of a control module 10 according to an implementation of this application. In a possible implementation, the third sealing structure 430 includes a first sealing rubber strip 431 and a first protective cover 432. A first hole in communication with the first accommodation space 101 is provided on the first housing 110. The first connector 130 penetrates the first hole. One end of the first connector 130 extends into the first accommodation space 101 and is fastened to the first circuit board 120, and the other end of the first connector 130 extends to the outside of the first accommodation space 101. The first protective cover 432 covers one end that is of the first connector 130 and that is away from the first circuit board 120. The first protective cover 432 and a surface that is of the first housing 110 and that is away from the first circuit board 120 are sealed through the first sealing rubber strip 431.

One part of the first connector 130 is located in the first accommodation space 101, and the other part of the first connector 130 is located in the first protective cover 432. The first protective cover 432 is detachably connected to the first housing 110 in a sealed manner through the first sealing rubber strip 431. The first sealing rubber strip 431 and the first protective cover 432 are disposed to seal both the first accommodation space 101 and a space in the first protective cover 432. In this case, the first connector 130 is disposed in contact with the first housing 110, and the first connector 130 and the first housing 110 are not in a nondetachable connection. The first connector 130 may be directly welded to the first circuit board 120. During disassembly, the first housing 110 may be directly detached from the cooling plate 300, the first protective cover 432 may be detached, and then the first circuit board 120 and the first connector 130 are detached from the first housing 110 together.

In an implementation, the first sealing rubber strip 431 may be fastened to the first housing 110 in advance, and the first protective cover 432 abuts against the first sealing rubber strip 431 to implement sealing. In this case, the first sealing rubber strip 431 may be completely located on the first enclosure frame 111, or may be partially located on the first enclosure frame 111 and partially located on the first cover plate 112. In an implementation, the first sealing rubber strip 431 is fastened to the first protective cover 432 in advance, and the first sealing rubber strip 431 abuts against the first housing 110 to implement sealing. In an implementation, a cable is disposed at one end that is of the first connector 130 and that is away from the first circuit board 120. A side that is of the first protective cover 432 and that is away from the first circuit board 120 is provided with openings opposite each other to allow the cable to pass through, and the cable and the openings may be sealed and fastened by dispensing adhesive.

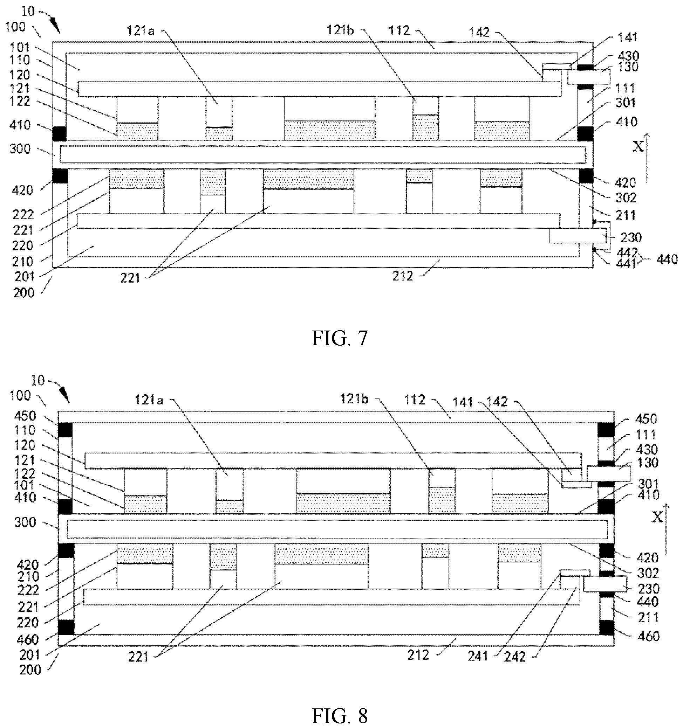

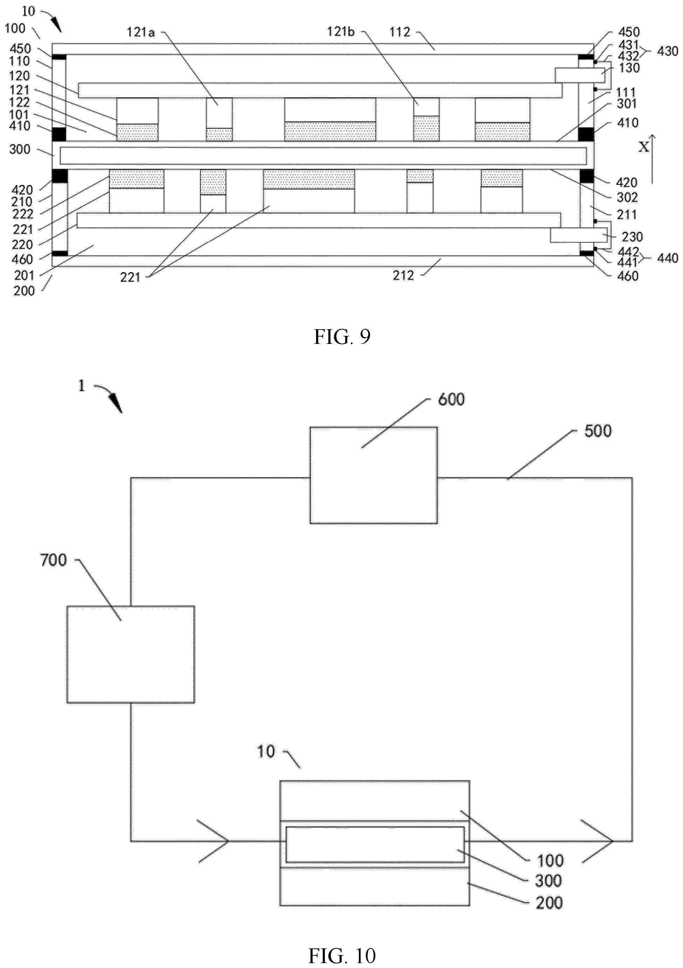

Refer to FIG. 8 and FIG. 9. In a possible implementation, the first housing 110 includes a first enclosure frame 111 and a first cover plate 112 that is located on the first enclosure frame 111 and that is away from the first surface 301. The first enclosure frame 111, the first cover plate 112, and the first surface 301 enclose the first accommodation space 101. A fifth sealing structure 450 is further disposed between the first enclosure frame 111 and the first cover plate 112. The fifth sealing structure 450 is located between the first enclosure frame 111 and the first cover plate 112, and is detachably connected to the first enclosure frame 111 and the first cover plate 112 separately. The fifth sealing structure 450 is configured to seal the first enclosure frame 111 and the first cover plate 112. The first enclosure frame 111 is detachably connected to the first surface 301 in a sealed manner. The first cover plate 112 is located on a side that is of the first enclosure frame 111 and that is away from the first surface 301 along the first direction X. In this implementation, the first cover plate 112 is parallel or approximately parallel to the first surface 301. The fifth sealing structure 450 is disposed, so that maintenance of the first circuit board 120 is more convenient.

In an implementation, the control module 10 further includes a first connection board 141 and a first circuit board connector 142 disposed on the first connection board 141. The first connection board 141 is fastened to the first connector 130. The first circuit board 120 is detachably connected to the first connection board 141 through the first circuit board connector 142. The first circuit board 120 is located on a side that is of the first circuit board connector 142 and that is away from the first surface 301. When the first circuit board 120 is detached, the first cover plate 112 is directly removed, and then the first circuit board 120 is pulled out in a direction along the first direction X away from the cooling plate 300. Such a disassembly manner is convenient and does not damage the first circuit board 120, and the first housing 110 does not need to be detached from the cooling plate 300.

In a possible implementation, the control module 10 further includes a second connector 230 (as shown in FIG. 3). The second connector 230 penetrates the second housing 210. Two ends of the second connector 230 are respectively located inside and outside the second accommodation space 201. A fourth sealing structure 440 is disposed on a periphery of the second connector 230. The fourth sealing structure 440 is connected to the second housing 210 to isolate the second accommodation space 201 from the outside. The second connector 230 is configured to implement information exchange between the second circuit board 220 and the outside. The second connector 230 is electrically connected to the second circuit board 220 inside the second accommodation space 201, the second connector 230 extends from the inside of the second accommodation space 201 to the outside of the second accommodation space 201, and the second connector 230 and the second housing 210 are sealed through the fourth sealing structure 440.

In an implementation, the electronic control unit further includes a connector. That is, an entirety of the second circuit board 220, the second housing 210, and the second connector 230 is referred to as the first electronic control unit 100. In an implementation, the second connector 230 may be a CAN connector, an Ethernet connector, a camera connector, or the like. In an implementation, the control module 10 may include a plurality of second connectors 230. The plurality of second connectors 230 may be connectors of a same type, or may be connectors of different types. To enable the control module 10 to adapt to various situations, a large quantity or a plurality of types of second connectors 230 may be preset, and then some of the second connectors 230 are selected for use according to an actual requirement. In an implementation, the second connector 230 may also be a standardized connector, and a quantity of the second connectors 230 may be increased or decreased to adapt to requirements for a quantity of the second connectors 230 in different situations.

In an implementation, the second housing 210 includes a second enclosure frame 211 and a second cover plate 212 (as shown in FIG. 3) that is located on the second enclosure frame 211 and that is away from the first surface 301. The second enclosure frame 211, the second cover plate 212, and the first surface 301 enclose the second accommodation space 201. The second connector 230 is disposed on the second enclosure frame 211.

Because an outer surface of the second connector 230 is usually in an irregular shape, if the fourth sealing structure 440 is a sealing rubber strip and the second connector 230 is directly connected to the second housing 210 in a sealed manner through the sealing rubber strip, a shape of the sealing rubber strip needs to be attached to the outer surface of the second connector 230. That is, the shape of the sealing rubber strip also needs to be an irregular shape. This implementation is feasible, but is inconvenient. Therefore, to resolve a sealing problem between the second connector 230 and the second housing 210, two implementations are provided in this application. First, the second connector 230 is fastened and sealed on the second housing 210 by dispensing adhesive or welding (as shown in FIG. 3). In this case, to ensure maintenance convenience of the second circuit board 220, the second circuit board 220 and the second connector 230 are disposed in a detachable connection, to ensure sealing performance of the second accommodation space 201 and convenience of disassembly and assembly of the second circuit board 220. Second, a second protective cover 442 with a more regular outer surface is disposed on an outer side of the second connector 230 (as shown in FIG. 6). Then, a second sealing rubber strip 441 is disposed to implement sealing of an entirety of the second connector 230 and the second protective cover 442 with the second housing 210. In this case, the second connector 230 is in a detachable connection relationship with the second housing 210. If the second circuit board 220 is in a nondetachable connection with the second connector 230, an entirety of the second circuit board 220 and the second connector 230 may be detached for maintenance when the second circuit board 220 is maintained.

A sealed connection manner between the second connector 230 and the second housing 210 provided in this application is simpler to implement and more operable. For details, refer to the following descriptions.

In a possible implementation, a second hole in communication with the second accommodation space 201 is provided on the second housing 210, the fourth sealing structure 440 is adhesive, the second connector 230 is fastened in the second hole by dispensing the adhesive, and one end of the second connector 230 extends into the second accommodation space 201 and is detachably connected to the second circuit board 220. In this implementation, the second hole is provided on the second enclosure frame 211, and the second connector 230 is fastened to the second enclosure frame 211 by dispensing the adhesive. In this case, the second circuit board 220 and the second connector 230 are disposed in a detachable connection, to ensure maintenance convenience of the second circuit board 220.

In an implementation, the second connector 230 may alternatively be fastened to the second housing 210 by welding and the like, or the second connector 230 and the second housing 210 are integrally formed.

In a possible implementation, the control module 10 further includes a second connection board 241 and a second circuit board connector 242 (as shown in FIG. 3) disposed on the second connection board 241. The second connection board 241 is fastened to the second connector 230. The second circuit board 220 is detachably connected to the second connection board 241 through the second circuit board connector 242. The second connection board 241 is fastened to the second connector 230 by welding or dispensing adhesive, and the second connector 230 may alternatively be fastened to the second connection board 241 by welding or dispensing adhesive. In this case, a manner of connecting the second connector 230 to the second housing 210 is not limited, and the second connector 230 and the second housing 210 are in a detachable connection or a nondetachable connection, which does not affect disassembly and assembly of the second circuit board 220.

In an implementation, the second connection board 241 may be a common conductive plate, and no component is disposed on the second connection board 241, or the second connection board 241 has only a few highly reliable passive components. In an implementation, the second circuit board connector 242 may be a BTB connector (namely, board-to-board Connectors).

In a possible implementation, the second circuit board 220 is located on a side that is of the second circuit board connector 242 and that is adjacent to the second surface 302. When the second circuit board 220 is detached, because the second housing 210 is detachably connected to the cooling plate 300 through the second sealing structure 420, the second housing 210 may be directly detached from the cooling plate 300, and then the second circuit board 220 is pulled out in a direction along the first direction X away from the second cover plate 212. Such a disassembly manner is convenient and does not damage the second circuit board 220. In a possible implementation, the fourth sealing structure 440 includes a second sealing rubber strip 441 and a second protective cover 442 (as shown in FIG. 6). A second hole in communication with the second accommodation space 201 is provided on the second housing 210. The second connector 230 penetrates the second hole. One end of the second connector 230 extends into the second accommodation space 201 and is fastened to the second circuit board 220, and the other end of the second connector 230 extends to the outside of the second accommodation space 201. The second protective cover 442 covers one end that is of the second connector 230 and that is away from the second circuit board 220. The second protective cover 442 and a surface that is of the second housing 210 and that is away from the second circuit board 220 are sealed through the second sealing rubber strip 441.

One part of the second connector 230 is located in the second accommodation space 201, and the other part of the second connector 230 is located in the second protective cover 442. The second protective cover 442 is detachably connected to the second housing 210 in a sealed manner through the second sealing rubber strip 441. The second sealing rubber strip 441 and the second protective cover 442 are disposed to seal both the second accommodation space 201 and a space in the second protective cover 442. In this case, the second connector 230 is disposed in contact with the second housing 210, and the second connector 230 and the second housing 210 are not in a nondetachable connection. The second connector 230 may be directly welded to the second circuit board 220. During disassembly, the second housing 210 may be directly detached from the cooling plate 300, the second protective cover 442 may be detached, and then the second circuit board 220 and the second connector 230 are detached from the second housing 210 together.

In an implementation, the second sealing rubber strip 441 may be fastened to the second housing 210 in advance, and the second protective cover 442 abuts against the second sealing rubber strip 441 to implement sealing. In this case, the second sealing rubber strip 441 may be completely located on the first enclosure frame 111, or may be partially located on the first enclosure frame 111 and partially located on the first cover plate 112. In an implementation, the second sealing rubber strip 441 is fastened to the second protective cover 442 in advance, and the second sealing rubber strip 441 abuts against the second housing 210 to implement sealing. In an implementation, a cable is disposed at one end that is of the second connector 230 and that is away from the second circuit board 220. A side that is of the second protective cover 442 and that is away from the second circuit board 220 is provided with openings opposite each other to allow the cable to pass through, and the cable and the openings may be sealed and fastened by dispensing adhesive.

In a possible implementation, the first electronic control unit 100 and the second electronic control unit 200 are sealed and fastened to the cooling plate 300 in different manners (as shown in FIG. 7). For example, in the first electronic control unit 100, the first circuit board 120 is detachably connected to the first connection board 141 through the first circuit board connector 142, and the first connector 130 is fastened to the first housing 110 in a sealed manner by dispensing adhesive or welding. In the second electronic control unit 200, the second connector 230 is fastened to the second circuit board 220 by welding. The fourth sealing structure 440 includes the second sealing rubber strip 441 and the second protective cover 442. The second protective cover 442 and the second housing 210 are sealed through the second sealing rubber strip 441, so that both the second accommodation space 201 and a space in the second protective cover 442 are sealed.

In a possible implementation, the second housing 210 includes a second enclosure frame 211 and a second cover plate 212 that is located on the second enclosure frame 211 and that is away from the second surface 302. The second enclosure frame 211, the second cover plate 212, and the second surface 302 enclose the second accommodation space 201. A sixth sealing structure 460 is further disposed between the second enclosure frame 211 and the second cover plate 212. The sixth sealing structure 460 is located between the second enclosure frame 211 and the second cover plate 212, and is detachably connected to the second enclosure frame 211 and the second cover plate 212. The sixth sealing structure 460 is configured to seal the second enclosure frame 211 and the second cover plate 212. The second enclosure frame 211 is detachably connected to the second surface 302 in a sealed manner. The second cover plate 212 is located on a side that is of the second enclosure frame 211 and that is away from the second surface 302 along the first direction X. In this implementation, the second cover plate 212 is parallel or approximately parallel to the second surface 302. The sixth sealing structure 460 is disposed, so that maintenance of the second circuit board 220 is more convenient.

In an implementation, the control module 10 further includes a second connection board 241 and a second circuit board connector 242 disposed on the second connection board 241. The second connection board 241 is fastened to the second connector 230. The second circuit board 220 is detachably connected to the second connection board 241 through the second circuit board connector 242. The second circuit board 220 is located on a side that is of the second circuit board connector 242 and that is away from the second surface 302. When the second circuit board 220 is detached, the second cover plate 212 is directly removed, and then the second circuit board 220 is pulled out in a direction along the first direction X away from the cooling plate 300. Such a disassembly manner is convenient and does not damage the second circuit board 220, and the first housing 110 does not need to be detached from the cooling plate 300.

It should be noted that structures of the first housing 110 and the second housing 210 in FIG. 8 are also applicable to the embodiment shown in FIG. 6.

FIG. 10 is a diagram of a heat dissipation system 1 according to an implementation of this application. An implementation of this application provides a heat dissipation system 1. The heat dissipation system 1 includes a heat dissipation component and the control module 10 according to any one of the foregoing implementations. The heat dissipation component is configured to dissipate heat for a cooling plate 300, so that the cooling plate 300 cools a first circuit board 120 and a second circuit board 220. In this implementation, the cooling plate 300 dissipates heat in a liquid cooling manner. The heat dissipation component includes a cooling pipe 500 and a pump 600. There is coolant inside the cooling pipe 500. The cooling plate 300 is in communication with the cooling pipe 500. The pump 600 is configured to drive the coolant to flow in the cooling pipe 500 and the cooling plate 300, so that the cooling plate 300 cools the first circuit board 120 and the second circuit board 220. In a process of circulation, the coolant can take away heat of the cooling plate 300, thereby reducing a temperature of the cooling plate 300. The pump 600 provides power for circulation of the coolant. In an implementation, the heat dissipation system 1 further includes a cooler 700, and the cooling plate 300 is further provided with a liquid inlet and a liquid outlet (not shown in the figure). Under the action of the pump 600, the coolant circulates between the cooler 700 and the cooling plate 300, and the heat of the cooling plate 300 is transferred to the cooler 700. The cooler 700 converts inflowing higher-temperature coolant into lower-temperature coolant and discharges the lower-temperature coolant. The lower-temperature coolant enters the cooling plate 300 through the liquid inlet to cool the first circuit board 120 and the second circuit board 220. The higher-temperature coolant in the cooling plate 300 flows out to the cooler 700 through the liquid outlet for cooling and further circulation.

In another implementation, when the cooling plate 300 dissipates heat through air cooling, the heat dissipation component includes a fan. The fan drives an airflow inside the cooling plate 300 to perform heat exchange with cold air in an external environment, to cool the cooling plate 300. Then, the first circuit board 120 and the second circuit board 220 are cooled by using the cooling plate 300.

In an implementation, the heat dissipation system may include one or more control modules 10.

Still refer to FIG. 1. An implementation of this application provides a vehicle. The vehicle includes a vehicle frame and the heat dissipation system described above. The heat dissipation system is mounted on the vehicle frame.

The vehicle is a wheeled vehicle that is driven or guided by a power apparatus and is used for passengers traveling on a road or for transporting articles and performing special engineering operations. The vehicle includes a two-wheeled, three-wheeled, or four-wheeled vehicle. The vehicle alternatively includes various special operation vehicles with specific functions, such as an engineering rescue vehicle, a sprinkling truck, a suction-type sewer scavenger, a cement mixer, a crane truck, and a medical vehicle. The vehicle may be an electric vehicle or an oil-fueled vehicle. The electric vehicle may be but is not limited to a pure electric vehicle (Pure Electric Vehicle/Battery Electric Vehicle, PEV/BEV), a hybrid electric vehicle (Hybrid Electric Vehicle, HEV), a range extended electric vehicle (Range Extended Electric Vehicle, REEV), a plug-in hybrid electric vehicle (Plug-in Hybrid Electric Vehicle, PHEV), or a new energy vehicle (New Energy Vehicle). This is not limited in this application.

The vehicle frame, serving as a structural framework of the vehicle, is configured to support, fasten, and connect a heat dissipation system of the vehicle, and bear load from the inside of a vehicle system and from an external environment. In a running process of the vehicle, an electronic control unit device in the vehicle generates heat, and a heat dissipation system can provide good heat dissipation for an electronic device such as an electronic control unit, to ensure that the electronic control unit can work stably and with high performance. It should be understood that the vehicle may include one or more heat dissipation systems, and application of the heat dissipation system may not be limited to the vehicle, but may be further used in another mechanical device.

The control module, the heat dissipation system, and electronic device provided in embodiments of this application are described in detail above. The principle and embodiments of this specification are described herein with specific examples. The descriptions about the foregoing embodiments are merely provided to help understand the method and core ideas of this application. In addition, a person of ordinary skill in the art can make modifications to specific embodiments and application scopes according to the ideas of this application. Therefore, in conclusion, the content of this specification shall not be construed as a limitation on this application.

## Claims

1. A control module, wherein the control module comprises:
a cooling plate, comprising a first surface and a second surface that are arranged along a thickness direction;
a first housing, located on a same side as the first surface and enclosing a first accommodation space with the first surface, wherein the first housing is detachably connected to the cooling plate in a sealed manner;
a first circuit board, located in the first accommodation space and detachably connected to the first housing, wherein a first chip is disposed on a side that is of the first circuit board and that faces the first surface, a first heat conduction structure is disposed between the first chip and the first surface, and the cooling plate dissipates heat for the first chip by using the first heat conduction structure;
a second housing, located on a same side as the second surface and enclosing a second accommodation space with the second surface, wherein the second housing is detachably connected to the cooling plate in a sealed manner; and
a second circuit board, located in the second accommodation space and detachably connected to the second housing, wherein a second chip is disposed on a side that is of the second circuit board and that faces the second surface, a second heat conduction structure is disposed between the second chip and the second surface, and the cooling plate dissipates heat for the second chip by using the second heat conduction structure.

2. The control module according to claim 1, wherein the control module further comprises a first sealing structure, and the first sealing structure is located between the first housing and the first surface, and is configured to seal the first housing and the first surface; and/or
the control module further comprises a second sealing structure, and the second sealing structure is located between the second housing and the second surface, and is configured to seal the second housing and the second surface.

3. The control module according to claim 1, wherein the control module further comprises a first connector, the first connector penetrates the first housing, two ends of the first connector are respectively located inside and outside the first accommodation space, a third sealing structure is disposed on a periphery of the first connector, and the third sealing structure is connected to the first housing to isolate the first accommodation space from the outside.

4. The control module according to claim 3, wherein a first hole in communication with the first accommodation space is provided on the first housing, the third sealing structure is adhesive, the first connector is fastened in the first hole through the adhesive, and one end of the first connector extends into the first accommodation space and is detachably connected to the first circuit board.

5. The control module according to claim 4, wherein the control module further comprises a first connection board and a first circuit board connector disposed on the first connection board, the first connection board is fastened to the first connector, and the first circuit board is detachably connected to the first connection board through the first circuit board connector.

6. The control module according to claim 5, wherein the first circuit board is located on a side that is of the first circuit board connector and that is adjacent to the first surface.

7. The control module according to claim 3, wherein the third sealing structure comprises a first sealing rubber strip and a first protective cover, a first hole in communication with the first accommodation space is provided on the first housing, the first connector penetrates the first hole, one end of the first connector extends into the first accommodation space and is fastened to the first circuit board, the other end of the first connector extends to the outside of the first accommodation space, the first protective cover covers one end that is of the first connector and that is away from the first circuit board, and the first protective cover and a surface that is of the first housing and that is away from the first circuit board are sealed through the first sealing rubber strip.

8. The control module according to any one of claims 1 to 7, wherein the first housing comprises a first enclosure frame and a first cover plate that is located on the first enclosure frame and that is away from the first surface, and the first enclosure frame, the first cover plate, and the first surface enclose the first accommodation space; and a fifth sealing structure is further disposed between the first enclosure frame and the first cover plate, the fifth sealing structure is located between the first enclosure frame and the first cover plate, and is detachably connected to the first enclosure frame and the first cover plate separately, and the fifth sealing structure is configured to seal the first enclosure frame and the first cover plate.

9. A heat dissipation system, wherein the heat dissipation system comprises a heat dissipation component and the control module according to any one of claims 1 to 8, and the heat dissipation component is configured to dissipate heat for a cooling plate, so that the cooling plate cools a first circuit board and a second circuit board.

10. An electronic device, wherein the electronic device comprises a device body and the heat dissipation system according to claim 9, and the heat dissipation system is mounted on the device body.
